# EUROPEAN PATENT SPECIFICATION

(11) **EP 4 359 806 B1**
(45) Date of publication and mention of the grant of the patent: **15.04.2026**
(21) Application number: 22733129.5
(22) Date of filing: 15.06.2022
(51) Int. Cl.: G01R 19/00, G01R 19/32, G01R 31/42

(54) **AN ELECTRIC CURRENT MEASURING ARRANGEMENT, A VOLTAGE SOURCE CONVERTER AND A METHOD FOR OPERATION OF THE CONVERTER**
STROMMESSANORDNUNG, SPANNUNGSQUELLENWANDLER UND VERFAHREN ZUM BETRIEB DES WANDLERS
AGENCEMENT DE MESURE DE COURANT ÉLECTRIQUE, CONVERTISSEUR DE SOURCE DE TENSION ET PROCÉDÉ DE FONCTIONNEMENT DU CONVERTISSEUR

(30) Priority: 23.06.2021 SE 2150811
(43) Date of publication of application: 01.05.2024
(73) Proprietor: ALSTOM Holdings, 93400 Saint-Ouen-sur-Seine (FR)
(72) Inventor: VELANDER, Erik, 723 41 Västerås (SE); JANSSON, Magnus, 635 36 Kvicksund (SE); TROSTÉN, Torbjörn, 725 97 Västerås (SE); ASHOK, Kanani, 722 28 Västerås (SE)
(74) Representative: Bjerkén Hynell KB
(86) International application number: PCT/EP2022/066261
(87) International publication number: WO 2022/268595

(56) References cited:
- EP-A1- 3 236 567
- US-A1- 2007 176 626

## Description

### TECHNICAL FIELD OF THE INVENTION

The present invention relates to an electric current measuring arrangement configured to measure an electric current in an electric power converter, which converter comprises
- a half bridge with two current valves connected in series and each comprising a rectifying diode and at least a first of the valves has a semiconductor device of turn-off type connected in anti-parallel therewith, a midpoint of the half bridge between the two current valves being connected to a first of opposite sides of the half bridge and opposite ends of the series connection of the valves being connected to a second of said opposite sides of the half bridge, and
- a gate drive unit having a gate drive part configured to control the semiconductor device of at least the first of the current valves to turn on and off to transfer electric power between said first and second sides of the half bridge.

The invention is not restricted to any particular location of an electric power converter to be subjected to an electric current measurement by such an arrangement, but the use thereof in a track-bound vehicle, such as a rail vehicle, will in some parts of this disclosure be explained for illuminating the invention but accordingly not restrict the invention to that application.

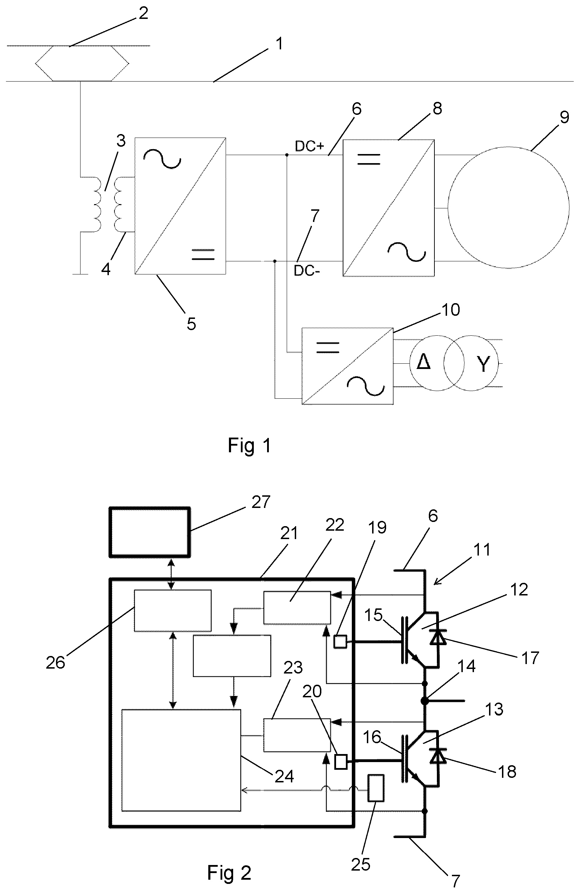

The half bridge in said measuring arrangement may in that particular application be present in any of the voltage source converters included in a track-bound vehicle 1 shown in Fig. 1, where it is schematically illustrated how electric power may be fed to the vehicle 1 from an AC-supply line 2 and used in the vehicle. The vehicle is configured to move along the AC-supply line 2, which acts as an AC-source when transferring electric power to the vehicle and an AC-load when receiving electric power from the vehicle when braking. The AC-supply line 2 may for example carry a single phase alternating voltage of 15 kV and 16 2/3 Hz (Sweden, Germany etc.) or 25 kV and 50 Hz (Denmark, China, India etc.). The vehicle has a transformer 3 for transforming the voltage from the supply line 2 to a suitable level. A secondary winding 4 of the transformer is connected to a line converter module 5 for delivering a direct voltage of for example 0,8-3 kV on the output thereof. The two poles 6, 7 of that direct voltage link are connected to a machine converter module 8 including a voltage source converter being controlled to deliver a three phase alternating voltage on the output thereof to a traction motor 9 in the form of an electric machine for driving the vehicle. The two direct voltage poles 6, 7 are also connected to the input of an auxiliary converter module 10 including a voltage source converter controlled to deliver a three phase alternating voltage on the output thereof to a distribution network to sockets arranged in the track-bound vehicle such as for connection of computers, and to lightening, heating and other appliances.

In case of a direct current fed track-bound vehicle the supply line will instead be a DC-supply line, and the transformer and the line converter module shown in Fig. 1 will then normally be replaced by a filter.

The converter modules of an electric power converter shown in Fig. 1 will have a gate drive unit mentioned in the introduction and how this may operate is for example disclosed in EP 3 236 567 A1. The half bridges controlled by a said gate drive unit and which may be subjected to current measurements may be the half bridges present in the converters and having the midpoint connected to an AC phase on the AC side of the converter or a half bridge forming a brake or overvoltage chopper included in the converter. Another possibility is that the half bridge in question is included in a voltage step-up chopper of a battery charger connected to the output of a said auxiliary converter module through a rectifier for charging auxiliary batteries arranged in the track-bound vehicle to supply all DC auxiliary loads and electronics of the vehicle.

### BACKGROUND ART

For the control of an electric power converter as the one schematically illustrated in Fig. 1 it is crucial to know the value of currents flowing in connection with the various half bridges included therein and mentioned above. It is for that sake known to have costly and bulky currents sensors arranged where these currents are to be measured.

Such a converter is found in prior art document US2007/176626A1, which discloses a current sensing arrangement for a half-bridge with high-side/low-side IGBT's/freewheeling diodes. The collector-emitter drop across the IGBT is sensed as a first voltage, and a second voltage is sensed across a parasitic resistance. Both voltages are functions of IGBT current and temperature. An algorithm calculates the current based on the two measurements. Further, current is sensed across parasitic resistors at the output of the half-bridge.

### SUMMARY OF THE INVENTION

The object of the present invention is to provide a voltage source converter according to appended independent claim 1.

Thus, by measuring the voltage drop across the rectifying diode of one of the current valves of the half bridge when the diode is conducting and when the gate drive part is controlling the semiconductor device of the other current valve to be off and/or the voltage drop across a semiconductor device, when it is conducting, controlled by the gate drive part to be turned on, it may be utilized that such a voltage drop value depends on the value of the current flowing through the current valve, and by knowing the temperature of the rectifying diode or semiconductor device in question a reliable value of said current may be calculated. The voltage drop measurement may for example be carried out as disclosed in EP 3 236 567 A1 or WO 2020/104204 A1. The temperature measurement may for example be carried out by a temperature sensor arranged on a plate or board on which the current valves are mounted, or even better by a temperature sensor incorporated in the semiconductor device and diode module. The expression "measuring the temperature in the vicinity of a current valve" as used in this disclosure includes both measuring the temperature outside and close to the current valve and inside the current valve.

According to an example the arrangement is configured to measure an electric current in an electric power converter which further comprises a battery charger having said half bridge operating as a step-up battery chopper with a DC source connected to said midpoint of the half bridge with a DC voltage thereof applied across said first current valve and a battery to be charged connected to said second side of the half bridge, and said calculating unit is configured to calculate and deliver a value of the current flowing through the current valve for which a voltage drop measurement is carried out and by that deliver a value of a battery chopper input current flowing into the battery charger from said DC source. The battery chopper input current measurement enabled by such an arrangement is used for the protection of the battery charger against high current and also to estimate the temperature of a transformer connected to the input of the battery charger to protect this against overheating. It is possible to obtain this without any need of a costly and bulky battery chopper input current sensor.

In a voltage source converter according to the invention it is possible to have an electric current measuring arrangement according to the invention for omitting a costly and bulky current sensor, and, specifically, for checking the functionality of a current sensor used in such a voltage source converter.

According to an embodiment of the invention the voltage source converter comprises a current sensor configured to measure the current between said midpoint of the half bridge and said AC load/source and a member configured to compare the current value delivered by said calculating unit and the value of the current measured by the current sensor and by the result of this comparison deliver a judgement of the state of said sensor. Conventional such current sensors used for phase current measurements may be subjected to a failure making them able to measure current only in one direction, and such a failure may then be detected in a voltage source converter according to this embodiment of the invention.

According to another embodiment of the invention the voltage source converter comprises three said half bridges each having a said gate drive unit with said first and second gate drive parts for creating a three phase AC fundamental voltage and current on said AC side and it is then possible to have a separate current sensor in at least two of the three half bridges to measure the current between said midpoint of the half bridge and said AC load/source.

According to another embodiment of the invention said three half bridges comprises a said voltage drop measuring member and a member configured to compare the current value delivered by said calculating unit for the half bridge and the value of the current measured by the respective current sensor and by the result of this comparison deliver a judgement of the state of the sensor. The state of the at least two current sensors for at least two phases may by that be checked.

According to another embodiment of the invention the voltage source converter comprises a further half bridge with two current valves connected in series and configured to be connected to said opposite poles of a DC source/load, a first of said current valves comprising a semiconductor device of turn-off type and a rectifying diode connected in anti-parallel therewith, and the other current valve comprising at least a rectifying diode with the same conducting direction as the rectifying diode in the first current valve as seen in the direction of said series connection, and with a resistor connected in parallel with said other current valve, the converter comprising a gate drive unit having a gate drive part configured to control the semiconductor device of said first valve to turn on and off making this half bridge functioning as a brake chopper while burning electric power in said resistor when having the semiconductor device of the first valve turned on, said electric current measuring arrangement having a voltage drop measuring member applied to this further half bridge, and said calculating unit being configured to use information about the voltage drop measured by this member and the temperature associated with the current valve in question to calculate and deliver a value of the current flowing through the resistor. It is then possible to have a member in the voltage source converter configured to compare the value delivered of the current flowing through the resistor with an expected resistor current value and deliver a judgement of the state of the resistor by the result of this comparison. The purpose of the resistor is to protect the converter from overvoltage by burning excessive energy of said DC source and burn the energy coming from the traction motor at braking when no feedback possibilities are possible, e.g. when the voltage of the supply line is higher than the acceptable level. The invention makes it possible to detect when there is no brake chopper current when activated and a faulty resistor can by that be detected without having a dedicated costly and bulky current sensor. In case of a short-circuited brake resistor this may also be detected.

According to another embodiment of the invention the voltage source converter is configured to have said half bridges thereof connected to a DC source/load in the form of a DC supply line, and it comprises a unit configured to determine the line current flowing between said DC supply line and the voltage source converter by combining the results of current values delivered by the current sensors of the three half bridges and the value of the resistor current calculated. In the regulation of the traction motor power in a DC-fed system it is of vital importance to be aware of the line current which has to be limited to a maximum value for the actual line voltage. A value of this line current may in this embodiment of the voltage source converter be obtained by adding the result of the current value measurements of the brake chopper current to the phase current values obtained by the current sensors without the need of any physical sensor for the chopper current which saves costs and space for such a sensor.

According to another embodiment of the invention the semiconductor devices of the current valves are IGBTs (Insulated Gate Bipolar Transistors) or MOSFETs (Metal Oxide Semiconductor Field Effect Transistors).

There is also provided an example method for measuring an electric current in an electric power converter according to the appended independent method claim. The advantages of such a method and possible embodiments thereof appear clearly from the above discussion of the electric current measuring arrangement and the voltage source converter according to the invention.

Further advantages as well as advantageous features of the invention will appear from the following description of embodiments of the invention.

### BRIEF DESCRIPTION OF THE DRAWINGS

With reference to the appended drawings, below follows a specific description of embodiments of the invention cited as examples. In the drawings:
- Fig. 1: is a very schematic view illustrating how different types of converters of the type to which the present invention is directed may be arranged and controlled in a track-bound vehicle,
- Fig. 2: is a very schematic view illustrating the principles of current measuring in a half bridge according to the invention,
- Fig. 3: is a graph illustrating the voltage drop U across a semiconductor device versus current I in forward (to the right of the U ordinate) and backward (to the left of the U ordinate) direction making it possible to translate a measured voltage value to a current through the semiconductor device and the diode, respectively. The forward and backward voltage drops have in the reality different curves.
- Fig. 4: illustrates schematically a machine converter module connected to a traction motor in a DC-fed system to which the present invention is applied,
- Fig. 5: is a simplified graph of phase current versus time measured by a current sensor shown in Fig. 4 when subjected to a failure,
- Fig. 6: is a schematic circuit diagram of a battery charger with step up chopper to which current measurements according to the invention are applied, and
- Fig. 7: is a schematic view illustrating an electronic converter control unit for implementing the invention.

### DETAILED DESCRIPTION OF EMBODIMENTS OF THE INVENTION

Fig. 2 illustrates very schematically the principles of the current measurements according to the present invention showing a half bridge 11 with two current valves 12, 13 connected in series and having opposite ends connected to opposite poles 6, 7 of a DC source/load and a midpoint 14 between the two current valves forming an AC side of the converter. Each current valve has here a semiconductor device 15, 16 of turn-off type in the form of an IGBT and a rectifying diode 17, 18 connected in anti-parallel therewith. The semiconductor devices are controlled to turn on and off through gate drive parts 19, 20 of a gate drive unit 21 in common. Turn-off types semiconductor devices are in this disclosure defined as semiconductor devices acting as IGBTs and MOSFETs by being able to be controlled to be abruptly turned off enabling creating of a Pulse Width Modulation pattern thereby.

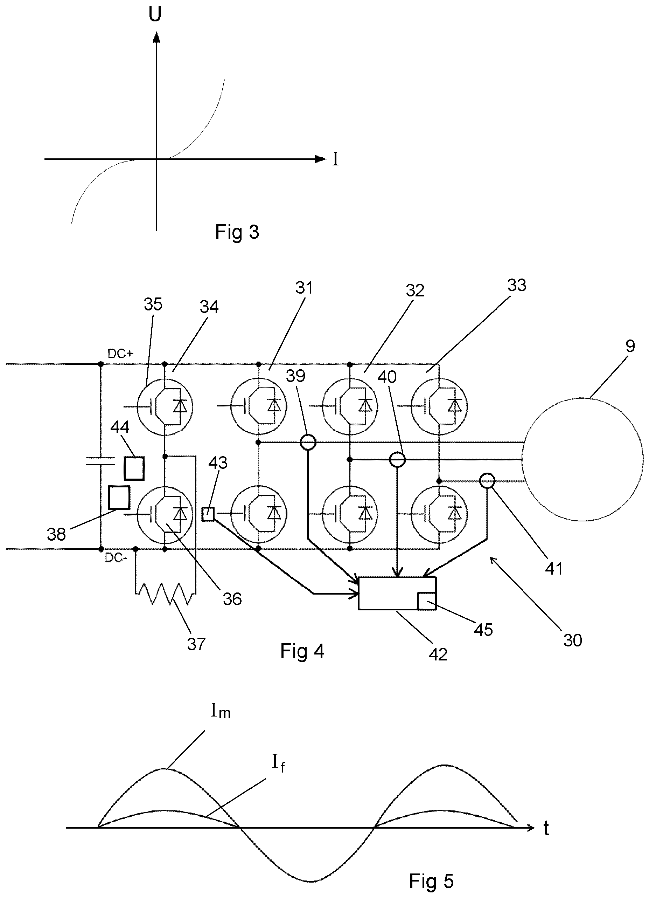

It is shown through boxes 22 and 23 how the voltage drop across each current valve is measured. During a half period of the AC current on the AC side of the converter a semiconductor device 15 is controlled to turn on and off current is flowing through the semiconductor device 15 to the AC side when turned on and through the rectifying diode 18 of the lower current valve when the semiconductor device 15 is turned off. Voltage drop values U measured will be depending upon said current I as shown in Fig. 3 but also the temperature of the current valves and especially the semiconductor devices thereof. The voltage measurement values are sent further to a unit 24 for signal processing while carrying out a temperature adaption of the voltage measurements made possible by information from a temperature sensor 25 measuring the temperature in the vicinity of the semiconductor device and the rectifying diode of the respective current valve. The unit 24 is configured to use information of the voltage drop and temperature measurements to calculate a value of the current flowing through the respective current valve and by that to or from the AC-side of the converter. Information about the current measured may then be sent through a voltage insulation block 26 to a converter control unit 27 controlling the converter. Accordingly, measurements of the current flowing in said half bridge may be carried out without a need of any bulky and costly current sensor. Here the temperature compensation is carried out in the gate drive unit 21, but it is within the scope of the invention to carry out the temperature compensation in the converter control unit instead.

Fig. 4 illustrates a voltage source converter 30 having four half bridges 31-34, three for three phases of the AC side thereof and one half bridge 34 forming a brake or overvoltage chopper. All four half bridges have a gate drive unit not shown. The brake chopper comprises a first 35 and second 36 current valve connected in series with a resistor 37 connected in parallel with the second current valve. The gate drive unit for this chopper not shown is configured to control the semiconductor device of the first current valve 35 to turn on and off making this half bridge functioning as a brake chopper while burning electric power in the resistor 37. A voltage drop measuring member in an electric current measuring arrangement according to the invention is applied to the brake chopper half bridge and a temperature sensor 44 is configured to measure the temperature in the vicinity of the semiconductor device of the first current valve of this half bridge for enabling a calculating unit 43 of the arrangement to calculate and deliver a value of the current flowing through the resistor. A member 38 is configured to compare the value delivered of the current flowing through the resistor with an expected resistor current value and by that deliver a judgement of the state of the resistor by the result of this comparison. A traction motor may have for instance four sets of four half bridges as shown in Fig. 4 included in the converter control unit and connected in parallel. If then a faulty brake chopper resistor is detected it is possible to still run the motor with a lower power by using the other three brake chopper resistors.

Furthermore, it is shown in the figure how each phase is provided with a current sensor 39-41, and these sensors are configured to send current information to a unit 42 also receiving information of the current through the resistor 37 from the electric current measuring arrangement according to the invention, so that in the case of DC source/load in the form of a DC supply line connected to the converter 30 the line current flowing between said DC supply line and the voltage source converter may be determined. A member 45 may also compare current values calculated with values of currents measured by the current sensors 39-41 for delivering a judgement of the state thereof. This comparing member may be included in the converter control unit.

Conventional, separate current sensors 39-41 used for phase current measurements may use +24V, 0V and -24V supply. If either +24V or -24V is lost then the sensors are able to measure current only in one direction, which is illustrated in Fig. 5 by the current value I_{f} delivered thereby and differing from the actual current Iₘ obtained by the current measurement according to the invention not only by a factor k, so that the failing sensor may in this way be detected.

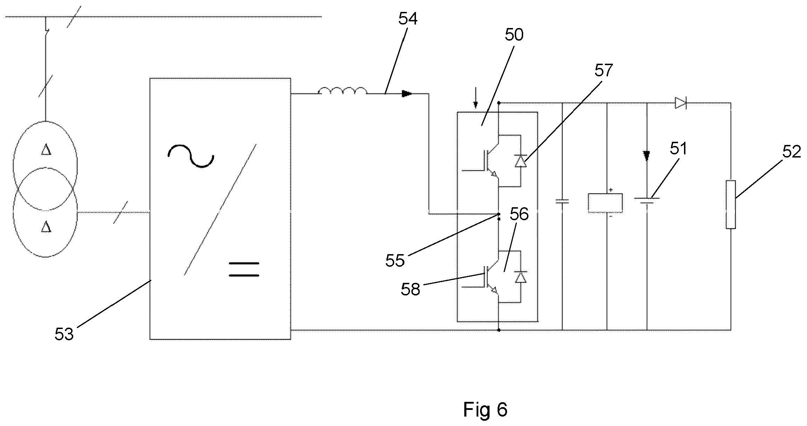

Fig. 6 illustrates a half bridge 50 in the form of a step up battery chopper used for charging a battery 51 to supply DC auxiliary loads 52 and electronics in a track-bound vehicle. A three phase voltage emanating from an auxiliary converter module of the electric power converter in a track-bound vehicle is connected to a rectifier 53, and the DC source 54 obtained thereby is connected to a midpoint 55 of the half bridge with a DC voltage thereof applied across the lower current valve 56, and the battery 51 to be charged is connected to the other side of the half bridge. Thus, the semiconductor device 58 of the current valve 56 is controlled to turn on and off for charging the battery, in which the current flowing into the midpoint is flowing through this semiconductor device or when this is turned off through the rectifying diode 57. The gate drive unit in the electric current measuring arrangement according to the invention is configured to measure the voltage drop across the semiconductor device 58 in the valve 56 or across the rectifying diode 57 when conducting and to calculate the battery chopper input current by also considering a temperature measured in the vicinity of the valve in question. This means that no separate current sensor has to be used for measuring the battery chopper input current which has to be measured for the protection of the battery charger against high current. This current measurement is also used to estimate battery charger input transformer temperature to protect it against overheating.

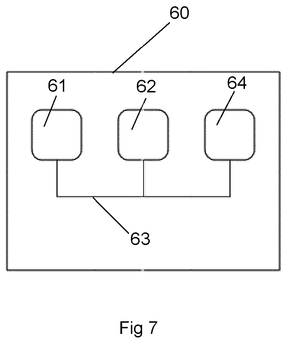

Computer program code for implementing a method is with advantage included in a computer program which can be read into the internal memory of a computer, e.g. the internal memory of an electronic converter control unit of a track-bound vehicle. Such a computer program is with advantage provided with a computer program product comprising a data storage medium which can be read by a computer and which has the computer program stored on it. Fig. 7 illustrates very schematically an electronic converter control unit 60 comprising an execution means 61, e.g. a central processor unit (CPU) for execution of computer software. The execution means 61 communicates with a memory 62, e.g. of the RAM type, via a data bus 63. The electronic converter control unit 60 also comprises a non-transitory data storage medium 64, e.g. in the form of a flash memory or a memory of the ROM, PROM, EPROM or EEPROM type. The execution means 61 communicates with the data storage medium 64 via the data bus 63. The computer program comprises computer program code for implementing a method according to the invention. Even better is to have the functions of the method for measuring an electric current in an electric power converter completely performed by a programmable digital circuit in the form of a Field-Programmable Gate Array, an FPGA, having a plurality of parallel signal branches making it operating faster than a computer microprocesson and the logical function of which may be changed by sending new programs thereto through a cable. Reference is made to WO 00/10243 showing such control.

The invention is of course in no way restricted to the embodiments described above, since many possibilities for modifications thereof are likely to be obvious to one skilled in the art without having to deviate from the scope of the invention defined in the appended claims.

In some of the current valves of the half bridges shown in the figures only a rectifying freewheeling diode is needed, as in the lower valve in the brake chopper and in the upper valve in the battery step-up chopper, but it may be rational to in spite of that have the same type of current valves everywhere in the electric system in question.

The diode may also be built in in the semiconductor device and not be a separate part.

## Claims

1. A voltage source converter comprising
• a half bridge (11, 31-34) with two current valves (12, 13, 35, 36) connected in series and configured to be connected to opposite poles (6, 7) of a DC source/load, each said current valve comprising a semiconductor device (15, 16) of turn-off type and a rectifying diode (17, 18) connected in anti-parallel therewith, a midpoint (14) of the half bridge between the two current valves forming an AC side of the converter and being configured to be connected to an AC load/source (9), and
• a gate drive unit (21) having a first gate drive part (19) configured to control the semiconductor device of a first of the current valves and a second gate drive part (20) configured to control the semiconductor device of the other, second of the current valves to turn on and off according to a Pulse Width Modulation pattern for creating an AC fundamental voltage and current on said AC side,
wherein the converter comprises an electric current measuring arrangement that comprises at least one of
a) a member (22, 23) configured to measure the voltage drop across the rectifying diode (17, 18, 57) of one of said current valves when it is conducting, and accordingly in the case of a said semiconductor device in that current valve the backward voltage drop of that device, when said gate drive part is controlling the semiconductor device of the other current valve to be off, and
b) a member (22, 23) configured to measure the voltage drop across a said semiconductor device (15, 16, 58) when it is conducting controlled by said gate drive part to be turned on, and accordingly the forward voltage drop of that semiconductor device,
**and that** the arrangement further comprises a member (25, 44) configured to measure the temperature in the vicinity of the current valve for which a voltage drop measurement is carried out and a calculating unit (24, 43) configured to receive voltage drop measurement values and temperature values associated with the same of said current valves and use this information to calculate and deliver a value of the current flowing through this current valve, wherein said voltage source converter comprises a current sensor (39-41) configured to measure the current between said midpoint of the half bridge and said AC load/source (9) and a member (45) configured to compare the current value delivered by said calculating unit (43) and the value of the current measured by the current sensor and by the result of this comparison deliver a judgement of the state of said sensor (39-41).

2. A voltage source converter according to claim 1, **characterized in that** it comprises three said half-bridges (31-33) each having a said gate drive unit (21) with said first and second gate drive parts (19,20) for creating a three phase AC fundamental voltage and current on said AC side.

3. A voltage source converter according to claim 2, **characterized in that** at least two of the three half bridges (31-33) has a current sensor (39-41) configured to measure the current between said midpoint of the half bridge and said AC load/source (9).

4. A voltage source converter according to claim 3, **characterized in that** said three half bridges (31-33) comprises a said voltage drop measuring member (22, 23) and a member (38) configured to compare the current value delivered by said calculating unit (43) for the half bridge and the value of the current measured by the respective current sensor (39-41) and by the result of this comparison deliver a judgement of the state of the sensor.

5. A voltage source converter according to claim 4 or 5, **characterized in that** it comprises a further half bridge (34) with two current valves (35, 36) connected in series and configured to be connected to said opposite poles (6, 7) of a DC source/load, a first (35) of said current valves comprising a semiconductor device of turn-off type and a rectifying diode connected in anti-parallel therewith, and the other current valve (36) comprising at least a rectifying diode with the same conducting direction as the rectifying diode in the first current valve as seen in the direction of said series connection, and with a resistor (37) connected in parallel with said other current valve (36), that it comprises a gate drive unit (21) having a gate drive part configured to control the semiconductor device of said first valve (35) to turn on and off making this half bridge (34) functioning as a brake chopper while burning electric power in said resistor (37) when having the semiconductor device of the first valve turned on, that said electric current measuring arrangement has a voltage drop measuring member applied to this further half bridge, and that said calculating unit (43) is configured to use information about the voltage drop measured by this member and the temperature associated with the current valve in question to calculate and deliver a value of the current flowing through the resistor.

6. A voltage source converter according to claim 5, **characterized in that** it comprises a member (38) configured to compare the value delivered of the current flowing through the resistor (37) with an expected resistor current value and deliver a judgement of the state of the resistor by the result of this comparison.

7. A voltage source converter according to claim 5 or 6, **characterized in that** it is configured to have said half bridges thereof connected to a DC source/load (6, 7) in the form of a DC supply line, and that it comprises a unit (42) configured to determine the line current flowing between said DC supply line and the voltage source converter by combining the results of current values delivered by the current sensors (39-41) of the three half bridges and the value of the resistor current calculated.

8. A voltage source converter according to any of claims 1-7, **characterized in that** the semiconductor devices (15, 16, 58) of the current valves (12, 13, 35, 36, 56) are IGBTs (Insulated Gate Bipolar Transistors) or MOSFETs (Metal Oxide Semiconductor Field Effect Transistors).

9. A track-bound vehicle (1) having at least one converter according to any of claims 1-8.

## Patentansprüche

1. Spannungsquellenwandler, umfassend
• eine Halbbrücke (11, 31-34) mit zwei Stromventilen (12, 13, 35, 36), die in Reihe geschaltet sind und konfiguriert sind, um mit entgegengesetzten Polen (6, 7) einer Gleichstromquelle/-last verbunden zu werden, wobei jedes Stromventil eine Halbleitervorrichtung (15, 16) vom Abschalttyp und eine Gleichrichterdiode (17, 18), die antiparallel dazu geschaltet ist, umfasst, wobei ein Mittelpunkt (14) der Halbbrücke zwischen den zwei Stromventilen eine Wechselstromseite des Wandlers bildet und konfiguriert ist, um mit einer Wechselstromlast/-quelle (9) verbunden zu werden, und
• eine Gate-Treibereinheit (21) mit einem ersten Gate-Treiberteil (19), der konfiguriert ist, um die Halbleitervorrichtung eines ersten der Stromventile zu steuern, und einem zweiten Gate-Treiberteil (20), der konfiguriert ist, um die Halbleitervorrichtung des anderen, zweiten der Stromventile zu steuern, um gemäß einem Pulsbreitenmodulationsmuster zum Erzeugen von Wechselstromgrundspannung und -strom auf der Wechselstromseite ein- und auszuschalten,
wobei
der Wandler eine elektrische Strommessanordnung umfasst, die mindestens eines umfasst aus:
a) einem Element (22, 23), das konfiguriert ist, um den Spannungsabfall über die Gleichrichterdiode (17, 18, 57) eines der Stromventile zu messen, wenn sie leitend ist, und dementsprechend im Fall einer Halbleitervorrichtung in diesem Stromventil den Rückwärtsspannungsabfall dieser Vorrichtung zu messen, wenn das Gate-Treiberteil die Halbleitervorrichtung des anderen Stromventils in den ausgeschalteten Zustand steuert, und
b) einem Element (22, 23), das konfiguriert ist, um den Spannungsabfall über eine Halbleitervorrichtung (15, 16, 58) zu messen, wenn sie leitend ist, die durch das Gate-Treiberteil in den eingeschalteten Zustand gesteuert ist, und dementsprechend den Vorwärtsspannungsabfall dieser Halbleitervorrichtung zu messen,
und dass die Anordnung ferner ein Element (25, 44), das konfiguriert ist, um die Temperatur in der Nähe des Stromventils zu messen, für das eine Spannungsabfallmessung ausgeführt wird, und eine Berechnungseinheit (24, 43) umfasst, die konfiguriert ist, um Spannungsabfallmesswerte und Temperaturwerte zu empfangen, die demselben der Stromventile zugeordnet sind, und diese Informationen zu verwenden, um einen Wert des durch dieses Stromventil fließenden Stroms zu berechnen und zu liefern, wobei der Spannungsquellenwandler einen Stromsensor (39-41), der konfiguriert ist, um den Strom zwischen dem Mittelpunkt der Halbbrücke und der Wechselstromlast/-quelle (9) zu messen, und ein Element (45) umfasst, das konfiguriert ist, um den durch die Berechnungseinheit (43) gelieferten Stromwert und den Wert des durch den Stromsensor gemessenen Stroms zu vergleichen und durch das Ergebnis dieses Vergleichs eine Beurteilung des Zustands des Sensors (39-41) zu liefern.

2. Spannungsquellenwandler nach Anspruch 1,
**dadurch gekennzeichnet, dass** er drei Halbbrücken (31-33) umfasst, die jeweils eine Gate-Treibereinheit (21) mit dem ersten und zweiten Gate-Treiberteil (19, 20) zum Erzeugen von dreiphasiger/m Wechselstromgrundspannung und -strom auf der Wechselstromseite aufweisen.

3. Spannungsquellenwandler nach Anspruch 2,
**dadurch gekennzeichnet, dass** mindestens zwei der drei Halbbrücken (31-33) einen Stromsensor (39-41) aufweisen, der konfiguriert ist, um den Strom zwischen dem Mittelpunkt der Halbbrücke und der Wechselstromlast/-quelle (9) zu messen.

4. Spannungsquellenwandler nach Anspruch 3,
**dadurch gekennzeichnet, dass** die drei Halbbrücken (31-33) ein Spannungsabfallmesselement (22, 23) und ein Element (38) umfassen, das konfiguriert ist, um den durch die Berechnungseinheit (43) gelieferten Stromwert für die Halbbrücke und den Wert des durch den jeweiligen Stromsensor (39-41) gemessenen Stroms zu vergleichen und durch das Ergebnis dieses Vergleichs eine Beurteilung des Zustands des Sensors zu liefern.

5. Spannungsquellenwandler nach einem der Ansprüche 4 oder 5,
**dadurch gekennzeichnet, dass** er eine weitere Halbbrücke (34) mit zwei Stromventilen (35, 36) umfasst, die in Reihe geschaltet sind und konfiguriert sind, um mit den entgegengesetzten Polen (6, 7) einer Gleichstromquelle/- last verbunden zu werden, wobei ein erstes (35) der Stromventile eine Halbleitervorrichtung vom Abschalttyp und eine Gleichrichterdiode, die anti-parallel dazu geschaltet ist, umfasst, und das andere Stromventil (36) mindestens eine Gleichrichterdiode mit derselben leitenden Richtung wie die Gleichrichterdiode in dem ersten Stromventil, gesehen in der Richtung der Reihenschaltung, und mit einem Widerstand (37), der parallel zu dem anderen Stromventil (36) geschaltet ist, umfasst, dass er eine Gate-Treibereinheit (21) mit einem Gate-Treiberteil umfasst, das konfiguriert ist, um die Halbleitervorrichtung des ersten Ventils (35) in den ein- und ausgeschalteten Zustand zu steuern, wodurch diese Halbbrücke (34) als ein Bremszerhacker fungiert, während elektrische Leistung in dem Widerstand (37) verbraucht wird, wenn die Halbleitervorrichtung des ersten Ventils eingeschaltet wird, dass die elektrische Strommessanordnung ein Spannungsabfallmesselement aufweist, das an diese weitere Halbbrücke angelegt wird, und dass die Berechnungseinheit (43) konfiguriert ist, um Informationen über den durch dieses Element gemessenen Spannungsabfall und die Temperatur, die dem betreffenden Stromventil zugeordnet ist, zu verwenden, um einen Wert des durch den Widerstand fließenden Stroms zu berechnen und zu liefern.

6. Spannungsquellenwandler nach Anspruch 5,
**dadurch gekennzeichnet, dass** er ein Element (38) umfasst, das konfiguriert ist, um den gelieferten Wert des durch den Widerstand (37) fließenden Stroms mit einem erwarteten Widerstandsstromwert zu vergleichen und eine Beurteilung des Zustands des Widerstands durch das Ergebnis dieses Vergleichs zu liefern.

7. Spannungsquellenwandler nach einem der Ansprüche 5 oder 6,
**dadurch gekennzeichnet, dass** er konfiguriert ist, um die Halbbrücken davon mit einer Gleichstromquelle/-last (6, 7) in der Form einer Gleichstromversorgungsleitung verbunden zu haben, und dass er eine Einheit (42) umfasst, die konfiguriert ist, um den Leitungsstrom, der zwischen der Gleichstromversorgungsleitung und dem Spannungsquellenwandler fließt, durch Kombinieren der Ergebnisse der Stromwerte, die durch die Stromsensoren (39 - 41) der drei Halbbrücken geliefert werden, und des Werts des berechneten Widerstandsstroms zu bestimmen.

8. Spannungsquellenwandler nach einem der Ansprüche 1 - 7,
**dadurch gekennzeichnet, dass** die Halbleitervorrichtungen (15, 16, 58) der Stromventile (12, 13, 35, 36, 56) IGBTs (Bipolartransistoren mit isoliertem Gate) oder MOSFETs (Metall-Oxid-Halbleiter-Feldeffekttransistoren) sind.

9. Spurgebundenes Fahrzeug (1) mit mindestens einem Wandler nach einem der Ansprüche 1 - 8.

## Revendications

1. Convertisseur de source de tension comprenant
• un demi-pont (11, 31-34) avec deux valves de courant (12, 13, 35, 36) connectées en série et configurées pour être connectées à des pôles opposés (6, 7) d'une source/charge de courant continu, chaque dite valve de courant comprenant un dispositif semi-conducteur (15, 16) de type à blocage et une diode de redressement (17, 18) connectée en anti-parallèle avec celle-ci, un point médian (14) du demi-pont entre les deux valves de courant formant un côté alternatif du convertisseur et étant configuré pour être connecté à une charge/source alternative (9), et
• une unité de commande de grille (21) ayant une première partie de commande de grille (19) configurée pour commander le dispositif à semi-conducteur d'une première des valves de courant et une deuxième partie de commande de grille (20) configurée pour commander le dispositif à semi-conducteur de l'autre, deuxième des valves de courant pour qu'il s'allume et s'éteigne conformément à un motif de Modulation de largeur d'impulsion (PWM) pour créer une tension fondamentale alternative et un courant sur ledit côté alternatif, dans lequel le convertisseur comprend un agencement de mesure de courant électrique qui comprend l'au moins un parmi
a) un élément (22, 23) configuré pour mesurer la chute de tension aux bornes de la diode de redressement (17, 18, 57) de l'une desdites valves de courant lorsqu'elle est conductrice, et par conséquent, dans le cas d'un dit dispositif à semi-conducteur dans cette valve de courant, la chute de tension vers l'arrière de ce dispositif, lorsque ladite partie de commande de grille commande le dispositif à semi-conducteur de l'autre valve de courant pour être éteinte, et
b) un élément (22, 23) configuré pour mesurer la chute de tension à travers un dit dispositif à semi-conducteur (15, 16, 58) lorsqu'il est conducteur commandé par ladite partie de commande de grille devant être activée, et par conséquent la chute de tension directe de ce dispositif à semi-conducteur,
et que l'agencement comprend en outre un élément (25, 44) configuré pour mesurer la température au voisinage de la valve de courant pour laquelle une mesure de chute de tension est effectuée et une unité de calcul (24, 43) configurée pour recevoir des valeurs de mesure de chute de tension et des valeurs de température associées à celles-ci desdites valves de courant et utiliser ces informations pour calculer et délivrer une valeur du courant circulant à travers cette valve de courant, dans lequel ledit convertisseur de source de tension comprend un capteur de courant (39-41) configuré pour mesurer le courant entre ledit point médian du demi-pont et ladite charge/source de courant alternatif (9) et un élément (45) configuré pour comparer la valeur de courant délivrée par ladite unité de calcul (43) et la valeur du courant mesuré par le capteur de courant et par le résultat de cette comparaison délivre une évaluation de l'état dudit capteur (39-41).

2. Convertisseur de source de tension selon la revendication 1, **caractérisé en ce qu'il** comprend trois dits demi-ponts (31-33) ayant chacun une dite unité de commande de grille (21) avec lesdites première et deuxième parties de commande de grille (19, 20) pour créer une tension et un courant fondamentaux alternatifs triphasés sur ledit côté alternatif.

3. Convertisseur de source de tension selon la revendication 2, **caractérisé en ce qu'au** moins deux des trois demi-ponts (31-33) ont un capteur de courant (39-41) configuré pour mesurer le courant entre ledit point milieu du demi-pont et ladite charge/source de courant alternatif (9).

4. Convertisseur de source de tension selon la revendication 3, **caractérisé en ce que** lesdits trois demi-ponts (31 à 33) comprennent un dit élément de mesure de chute de tension (22, 23) et un élément (38) configuré pour comparer la valeur de courant délivrée par ladite unité de calcul (43) pour le demi-pont et la valeur du courant mesuré par le capteur de courant respectif (39 à 41) et par le résultat de cette comparaison délivre une évaluation de l'état du capteur.

5. Convertisseur de source de tension selon la revendication 4 ou 5, **caractérisé en ce qu'il** comprend un autre demi-pont (34) avec deux valves de courant (35, 36) connectées en série et configurées pour être connectées auxdits pôles opposés (6, 7) d'une source/charge de courant continu, une première (35) desdites valves de courant comprenant un dispositif semi-conducteur de type à blocage et une diode de redressement connectée en anti-parallèle avec celle-ci, et l'autre valve de courant (36) comprenant l'au moins une diode de redressement avec le même sens de conduction que la diode de redressement dans la première valve de courant comme vu dans le sens de ladite connexion en série, et avec une résistance (37) connectée en parallèle avec ladite autre valve de courant (36), qu'il comprend une unité de commande de grille (21) ayant une partie de commande de grille configurée pour commander le dispositif à semi-conducteur de ladite première valve (35) pour qu'il s'allume et s'éteint, faisant que ce demi-pont (34) fonctionne comme un découpeur de frein tout en dissipant de l'énergie électrique dans ladite résistance (37) lorsqu'il a le dispositif à semi-conducteur de la première valve allumé, que ledit agencement de mesure de courant électrique a un élément de mesure de chute de tension appliqué à cet autre demi-pont, et que ladite unité de calcul (43) est configurée pour utiliser des informations concernant la chute de tension mesurée par cet élément et la température associée à la valve de courant en question pour calculer et délivrer une valeur du courant circulant à travers la résistance.

6. Convertisseur de source de tension selon la revendication 5, **caractérisé en ce qu'**il comprend un élément (38) configuré pour comparer la valeur délivrée du courant circulant à travers la résistance (37) à une valeur de courant de résistance attendue et délivrer une évaluation de l'état de la résistance par le résultat de cette comparaison.

7. Convertisseur de source de tension selon la revendication 5 ou 6, **caractérisé en ce qu'**il est configuré pour que lesdits demi-ponts de celui-ci soient connectés à une source/charge de courant continu (6, 7) sous la forme d'une ligne d'alimentation en courant continu, et **en ce qu'**il comprend une unité (42) configurée pour déterminer le courant de ligne circulant entre ladite ligne d'alimentation en courant continu et le convertisseur de source de tension en combinant les résultats des valeurs de courant délivrées par les capteurs de courant (39-41) des trois demi-ponts et la valeur de la résistance calculée.

8. Convertisseur de source de tension selon l'une quelconque des revendications 1 à 7, **caractérisé en ce que** les dispositifs à semi-conducteur (15, 16, 58) des valves de courant (12, 13, 35, 36, 56) sont des IGBT (transistors bipolaires à grille isolée) ou des MOSFET (transistors à effet de champ à oxyde métallique).

9. Véhicule sur rails (1) ayant au moins un convertisseur selon l'une quelconque des revendications 1 à 8.
